# EUROPEAN PATENT SPECIFICATION

(11) **EP 0 846 953 B1**
(45) Date of publication and mention of the grant of the patent: **24.10.2001**
(21) Application number: 97121442.4
(22) Date of filing: 05.12.1997
(51) Int. Cl.: G01R 1/073

(54) **Printed circuit board inspecting apparatus**
Apparat zur Inspektion von Leiterplatten
Appareil pour inspecter des circuits imprimés

(30) Priority: 05.12.1996 JP 32563796
(43) Date of publication of application: 10.06.1998
(73) Proprietor: Nidec-Read Corporation, Uji-shi, Kyoto 611 (JP)
(72) Inventor: Nishikawa, Hideo, Uji-shi, Kyoto 611 (JP); Miki, Takashi,Nidec-Read Corp., Uji-chi, Kyoto 611 (JP)
(74) Representative: Ritter und Edler von Fischern, Bernhard, Dipl.-Ing.

(56) References cited:
- EP-A- 0 354 080
- DE-A- 4 237 591
- DE-A- 19 507 127

## Description

The present invention relates to a printed circuit board inspecting apparatus, and particularly pertains to improvements of the versatility of a universal-type printed circuit board inspecting apparatus.

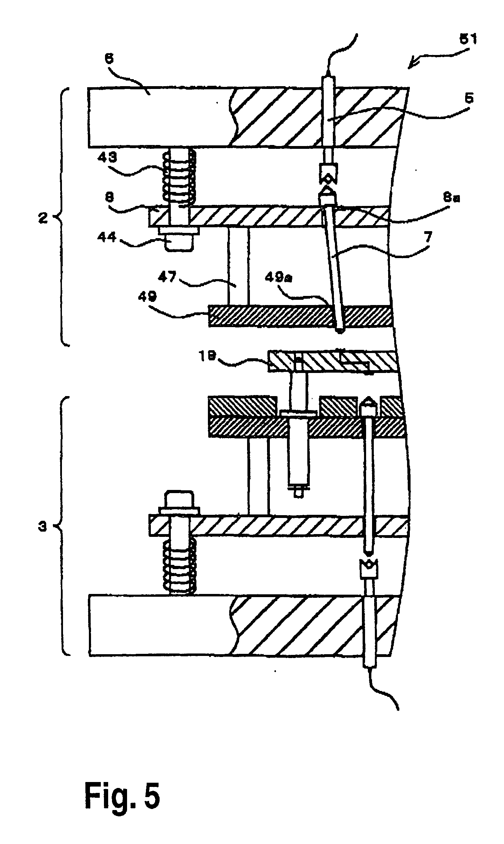

Conventional universal-type printed circuit board inspecting apparatus 51 as illustrated in Fig. 5, has upper jig 2 and lower jig 3. Upper jig 2 has base 6 on which probes 5 are mounted in matrix arrangement. Board 8 is coupled with base 6 through rods. Board 8 has through-holes 8a in the same position as that of probes 5. Board 8 is coupled with lower conversion board 49 through post 47. Lower conversion board 49 is formed with through-holes 49a at positions corresponding to the measuring points on the patterns printed circuit board 19 which is to be inserted and put on lower jig 3. Test pins 7 are respectively inserted into through-holes 8a and 49a. Test pins 7 cooperate with board 49 to convert the matrix arranged probe positions into actual measuring points.

Conductivity test is done in the following manner. Lower jig 3 is raised by a lift (not illustrated), bringing each one end of test pins 7 into contact with printed circuit board 19 to be tested and the other ends of test pins 7 are brought into contact with probes 5 in upper jig 2. The same happens to lower jig 3.

In such conventional universal-type printed circuit board inspection apparatus 51, any printed circuit board can be measured by replacing lower conversion board 49 with another one having through-holes 49a arranged according to the measuring points of printed circuit board to be inspected.

Nowadays, the pitches and spaces between printed circuit patterns become ever finer so that it is difficult to ensure accurate measurement with such conventional universal-type printed circuit board inspecting apparatus 51 that employs exchangeable lower conversion board.

To cope with such problem, an inspection apparatus was proposed which employed a translator board instead of the test pins. (See Japanese patent application No. Showa54-129211.)

However, the problems cited below occur when a translator board is mounted in space of test pins on such a conventional universal-type printed circuit board inspecting apparatus.

Conductivity test is made with lower jig 3 being raised by a lift (not illustrated). However, a given stroke is set for the movement of lower jig 3. Accordingly, if board 8, post 47 and conversion lower board 49 are removed from the universal-type printed circuit board inspecting apparatus 51, the present stroke will be shorter than the stroke required for the inspection, disabling the operation of printed circuit board inspecting apparatus.

If the lifting range of the lower jig 3 is changed to enable testing with the translator board to solve the above mentioned problem, inspections are possible only with a translator board. However, some inspections, such as those of relatively coarse-pitched printed circuit boards, are more easily done with the test pin system, because it is easier and cheaper to manufacture lower conversion boards 49 having through-holes 49a at given positions than to manufacture a translator board.

Moreover, when a printed circuit board that has been inspected, is reinspected, inspection is made with lower conversion board 49, which has been stored and having through holes that meet the pattern of the inspected printed circuit board. In such reinspection, translator board 13 must be remade once the stroke of lifting the lower jig is adjusted.

Accordingly, DE 42 37591 A describes an inspecting apparatus for inspecting conductivity between and among inspection points on a printed circuit board, comprising a plurality of probes arranged in a predetermined pattern, a translator board including a first set of terminals arranged in the same pattern as that of the probes and a second set of terminals arranged in the same pattern as that of the inspection points on the printed circuit board to be inspected, the terminals of the first set being respectively electrically interconnected with corresponding terminals of the second set, the translator board being exchangeably mounted on the apparatus; and interconnecting pins for electrically interconnecting the probes with corresponding terminals of the first set of the translator board. An object of the present invention is to provide a printed circuit board inspecting apparatus which is capable of using either a pitch converting pin or pitch converting board in accordance with patterns or types of the printed circuit board to be tested.

Accordingly an object of the present invention is to provide a printed circuit board inspection apparatus adapted for inspection of both fine and coarse pattern pitch printed circuit boards.

Another object of the present invention is to provide a printed circuit board inspection apparatus in which a translator board for fine pitch board and a conversion board for coarse pitch board are alternatively used.

Further object of the present invention is to provide a printed circuit board inspection apparatus wherein test pins for interconnecting probes and upper terminals of translator board are kept disengaged from the translator board while the apparatus is in rest condition.

Still further object of the present invention is to provide a printed circuit board inspection apparatus wherein test pins for interconnecting probes and upper terminals of translator board are kept disengaged from the probes while the apparatus is in rest condition.

According to the present invention, an inspecting apparatus for inspecting conductivity between and among inspection points on a printed circuit board, comprises a plurality of probes arranged in a predetermined pattern, a translator board including a first set of terminals arranged in the same pattern as that of the probes and a second set of terminals arranged in the same pattern as that of the inspection points on a printed circuit board to be inspected, the first set of terminals being respectively interconnected with corresponding terminals of the second set, the translator board being exchangeably mounted on the apparatus, and interconnecting pins for electrically interconnecting the probes with corresponding terminals of the first set of the translator board. This inspecting apparatus further comprises a supporting board for supporting the interconnecting pins and a biasing member for biasing the supporting board to keep off the tips of the interconnecting pins from the translator board while the apparatus is at rest.

With the apparatus of the present invention, a conventional conversion board as shown in Figure 5 can be exchanged with the translator board and used without substantially changing the stroke of a lift that lifts the printed circuit board to the position to be inspected. The conversion board has through holes arranged to correspond to the inspection points on the printed circuit board and respectively receive the interconnecting pins such that the pins may be brought into contact with the inspection points.

According to an embodiment of the present invention, a guide plate has a plurality of through-holed for guiding the interconnecting pins to the first set of terminals of the translator board. The guide plate may be coupled with the translator board with or without space therebetween. The set of the guide plate and the translator board may be exchanged with the conventional conversion board.

According to the embodiment of the present invention, three plates work as the guide plate. First plate has a plurality of through holes each of which has a diameter substantially same as that of the interconnecting pin to receive the latter in smooth fitting manner. Second plate has a plurality of through holes each of which is slightly larger than that of the interconnecting pins for loose fitting with the pin, allowing slight displacement of the second plate relative-to the pins. Third plate is integrally coupled with the second plate and relative to the pins. Third plate is integrally coupled with the second plate and the translator board and is to be driven therewith to adjust them relative to the pins.

According to the embodiment of the present invention, each tip of the interconnecting pins is loosely received by corresponding through-hole of the guide plate with a distance from the translator board while the apparatus is at rest.

The above and other objects, features and advantages of the present invention will be apparent from the following detailed description of the preferred embodiments of the present invention in conjunction with the accompanying drawings, in which
Fig. 1 is a partially cross-sectional schematic illustration of a printed circuit board inspection apparatus 1 as an embodiment of the present invention.
Fig. 2 is cross-sections view of main portion of a translator board.
Fig. 3 is a partially cross-sectional schematic illustration of an embodiment using translator lowerer 25.
Fig. 4 is a partially cross-section schematic illustration of another embodiment of the present invention which employs position adjusting mechanism.
Fig. 5.is a partially cross-section schematic illustration of conventional universal-type printed circuit board inspection apparatus 51.

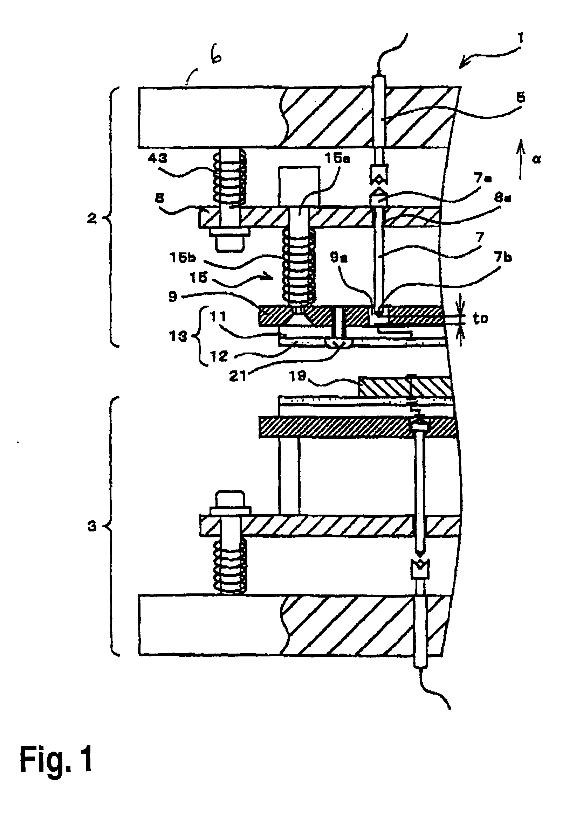

An embodiment of the present invention is described with reference to Fig. 1 which schematically illustrates a printed circuit board inspection apparatus 1 according to the present invention.

Printed circuit board inspecting apparatus 1 has upper jig 2 and lower jig 3. Upper jig 2 has base 6 on which probes 5 are mounted in matrix arrangement. Board 8 is coupled with base 6 through a rod on which spring 43 is wound around. Board 8 has through-holes 8a arranged in a matrix and board 9 also has through-holes 9a, which are at the same positions as those of through-holes 8. Test pins 7 extend through through-holes 8a and 49a. In the present embodiment, test pin 7 has a diameter of 0.4 mm, and through-holes 8a and 9a have respectively a diameter of 0.5 mm. Heads 7a of test pins 7 are retained on the upper side of board 8.

Pin raiser 15 is interposed between boards 8 and 9. Pin raiser 15 is composed of body 15a and spring 15b. Spring 15b urges the board 8 in the direction of the arrow α to move away from board 9. Thus, head 7a of test pin 7 is lifted in the direction of the arrow α, with tip 7b of test pin 7 being kept from contacting the upper surface of translator board 13 through clearance t0. Translator board 13 is fixed to board 9 with screws 21.

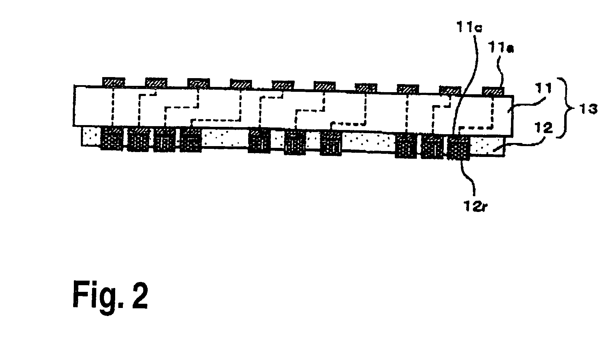

Next, description is about translator board 13, with reference to Fig. 2. The translator board is used for inspection of printed circuit boards of electric conductor patterns with pitches finer than those between the probes of a universal-type jig. The translator board 13 includes inspection electrodes 11c arranged to match the electric conductor pattern of a printed circuit board to be inspected. Translator board 13 includes converter 11 and electrically conductive rubber portion 12. Converter 11 is provided with electrodes 11a on the probe side and electrodes 11c on the inspection side. Electrode 11c on the inspection side is provided with electrically conductive rubber portion 12. Electrically conductive rubber portion 12 is equipped with non uniformly arranged PCR part 12r. The "Offgrid Adapter JP2000" manufactured by JSR Nippon Synthetic Rubber Co., Ltd. is used as translator board 13 in the present embodiment.

Printed circuit board 19 to be inspected is put on lower jig 3 in the conventional way. With the structure as mentioned above, pin raiser 15 between boards 8 and 9 prevents tip 7b from coming into contact with the measuring point of translator board 13 when no inspection occurs. At the time, the weight of test pin 7 is kept from translator board 13, preventing warping or damage of translator board 13.

Through-holes 8a and 9a are designed to be slightly broader in diameter than test pins 7. Pitches are converted by translator board 13, and test pins 7 can be held almost vertical, avoiding the problem that tips of the test pins contact translator board 13 at points displaced from predetermined position.

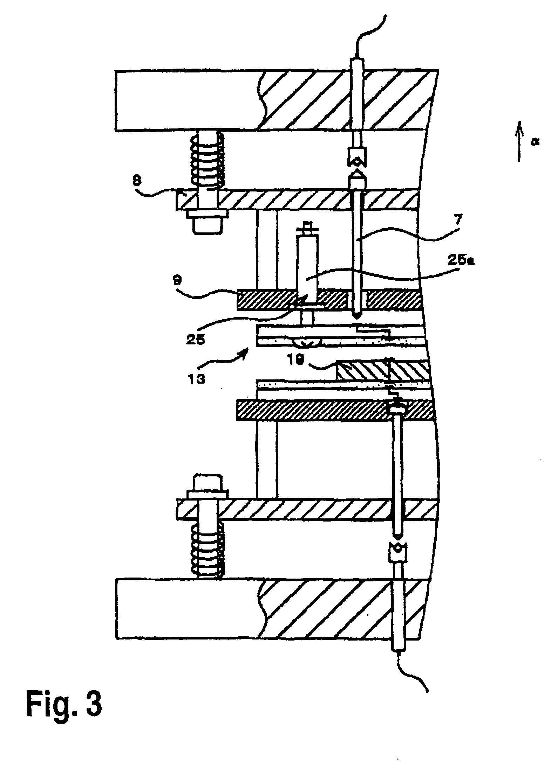

In the above mentioned embodiment, pin raiser 15 pulls up board 8 in the direction of the arrow α from board 9. It is possible that translator lowering member 25 urges translator board 13 in the direction opposite to the arrow α, as shown in Fig. 3. Within its body 25a, translator lowering member 25 incorporates a spring (not illustrated), which urges translator board 13 to move away from board 9.

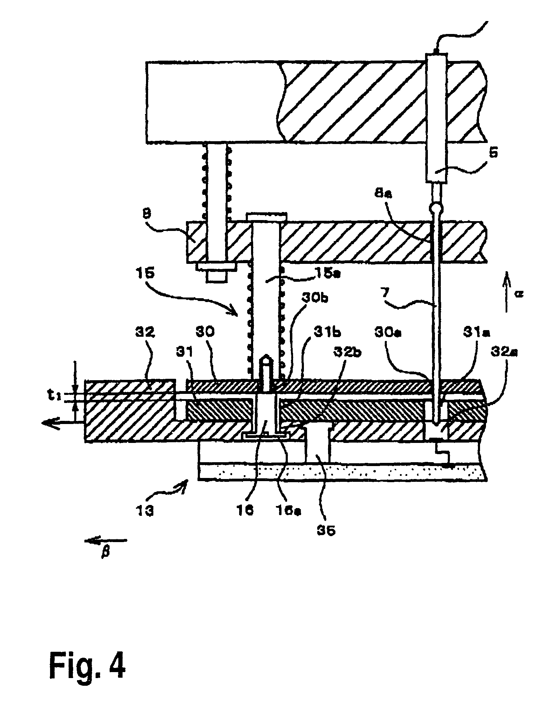

Explanation will then be made about another embodiment with reference to Fig. 4, which shows an embodiment in which the position of translator board 13 can be fine-adjusted relating to printed circuit board 19 to be inspected.

In this embodiment, a member corresponding to board 9 in Fig. 1 is composed of three boards 30, 31 and 32. Board 8 is formed with through-holes 8a respectively that receive test pin 7, as in the embodiment shown in Fig. 1. Board 30 is formed with through-holes 30a that respectively receive test pins 7, in the same manner as with board 8. Each test pin 7 is 0.4 mm in diameter, and each of through-holes 8a and 30a is 0.5 mm in diameter.

Boards 31 and 32 are respectively formed with through-holes 31a and 32a, which are slightly larger in diameter than test pin 7. In the present embodiment, the diameter of test pin 7 is 0.4 mm, and that of through-holes 31a and 32a 0.8 mm.

As in the embodiment shown Fig. 1, pin raiser 15 is provided between boards 8 and 30 to urge board 8 in the direction of the arrow α. Board 30 is formed with through-holes 30b. Boards 31 and 32 have through-holes 31b and 32b, respectively. Board 32 is formed with a spot facing of which a diameter is larger than that of head 16a of drop preventing screw 16. Drop preventing screw 16 is received by through-holes 31b and 32b, and the male screw of drop preventing screw 16 extends through through-holes 30b of board 30, and is screwed in pin raiser 15 to retain boards 31 and 32 on board 30.

Through-holes 31b and 32b loosely receive drop preventing screw 16, and boards 31 and 32 are suspended with clearance t1 from board 30. In this condition, boards 31 and 32 can be moved relative to board 30. Pin raiser 15 retains board 30 not to move in the direction of arrow β relative to board 8.

Positioning pin 35 retains translator board 13 and board 32 at positions.
Board 32 is connected to a drive (not shown) and can move in the direction of the arrow β or in its opposite direction. In this embodiment mentioned above, test pin 7 has a diameter of 0.4 mm, and through-holes 31a and 32a have diameters of 0.8 mm. Thus, test pin 7 can move by 0.2 mm to the right or left.

When the drive (not shown) moves board 32 in the direction of arrow β or oppositely, translator board 13 moves with board 32. In this case, test pin 7 is held vertical, as through-holes 31a and 32a are larger in diameter than test pin 7. Thus, without moving the entire upper jig, translator board 13 is easily positioned relative to printed circuit board 19 to be inspected.

Further the tips of test pins 7 are kept off from the patterns of translator board 13 in this embodiment so that the pattern will not be damaged when translator board 13 moves horizontally. Thus, instead of providing lower conversion board 49 as shown in Fig. 5, test pin 7 can be held vertical by providing loose through-holes 9a at the same positions as these of through-holes 8a as shown in Fig. 1, and translator board 13 is employed for pitch conversion. Then, the embodiment enables two types of inspection, one of which employs translator board 13 as in the conventional universal type printed circuit board inspection apparatus 51, and the other of which uses test pin 7 without translator board 13.

In the present embodiment, test pins 7 are held vertical extending through through-holes 8a and 30a. Accordingly, the embodiment is free from the problem that the tips of test pins 7 displace from inspection points when they engage a printed circuit board to be tested.

Although test pins 7 are held vertical in this embodiment, they may be arranged to be held obliquely as in the conventional way, with pitches being reconverted by translator board 13.

As test pin 7 is not removed in this embodiment, an inspection using translator board can be done with a conventional printed circuit board inspection apparatus, without changing the shape of the tip of the probe (a dip).

In the present embodiment, the position of translator board 13 can be adjusted, by slightly moving boards 31 and 32 horizontally (in X, Y, and θ directions) with the board 32 being connected with a drive. Board 8 may also be connected with a drive to adjust the positions of boards 8, 30, 31 and 32. In this case, if at least through-holes 8a are made loose, displacement of probe 5 can be absorbed. Other through-holes, 30a, 31a and 32a may be either loose holes or fitting holes.

While the invention has been particularly shown and described with reference to preferred embodiments thereof, it will be understood by those skilled in the art that the foregoing and other changes in form and details can be made therein without departing from the scope of the invention.

## Claims

1. An inspecting apparatus for inspecting conductivity between and among inspection points on a printed circuit board, said apparatus comprising:
a plurality of probes (5) arranged in a predetermined pattern;
a translator board (13) including a first set of terminals (11a) arranged in the same pattern as that of the probes and a second set of terminals (11c) arranged in the same pattern as that of the inspection points on a printed circuit board to be inspected, the first set of terminals (11a) being respectively electrically interconnected with corresponding terminals of the second set (11c), the translator board (13) being exchangeably mounted on the apparatus; and
interconnecting pins (7) for electrically interconnecting the probes (5) with corresponding terminals (11a) of the first set of the translator board;
**characterized by**:
a supporting board (8) for supporting the interconnecting pins (7) and a biasing member (15b) for biasing the supporting board (8) to keep off the tips (7b) of the interconnecting pins (7) from the translator board (13) while the apparatus is at rest.

2. A printed circuit board inspecting apparatus according to Claim 1, further comprising a guide plate (9) including a plurality of through-holes (9a) for guiding the interconnecting pins (7) to the first set of terminals (11a) of the translator board (13), said guide plate (9) being integrally coupled with the translator board (13).

3. A printed circuit board inspecting apparatus according to Claim 1, further comprising a first plate (30) having a plurality of through-holes (30a), each of which having a diameter substantially the same as that of the interconnecting pin (7) to receive the latter in smooth fitting manner; a second plate (31) having a plurality of through-holes (31a) each of which is slightly larger than that of the interconnecting pins (7) for loose fitting with the pins (7), allowing slight displacement of the second plate (31) relative to the pins (7); a third plate (32) integrally coupled with the second plate (31) and the translator board (13) and a driving member for adjusting the second and third plates (31, 32) and the translator board (13) relative to the pins (7).

4. A printed circuit board inspecting apparatus according to any one of Claims 1 to 3, wherein said predetermined pattern is a matrix and the supporting board (8) includes a plurality of through-holes (8a) arranged in said matrix, each of the interconnecting pins (7) having an enlarged head (7a) so as to be held on an upper side of the supporting board and wherein a diameter of each through-hole (8a) is larger than a diameter of the respective interconnecting pin (7) passing therethrough.

## Patentansprüche

1. Untersuchungsvorrichtung zum Untersuchen einer Leitfähigkeit zwischen und unter Untersuchungsstellen auf einer Leiterplatte, wobei die Vorrichtung folgendes aufweist:
eine Vielzahl von Sonden (5), die in einem vorbestimmten Muster angeordnet sind;
eine Umsetzungskarte (13), die eine erste Gruppe von Anschlüssen (11a) enthält, die im selben Muster wie demjenigen der Sonden angeordnet sind, und eine zweite Gruppe von Anschlüssen (11c), die im selben Muster wie demjenigen der Untersuchungsstellen auf einer zu untersuchenden Leiterplatte angeordnet sind, wobei die erste Gruppe von Anschlüssen (11a) jeweils elektrisch mit entsprechenden Anschlüssen der zweiten Gruppe (11c) verbunden ist, wobei die Umsetzungskarte (13) austauschbar an der Vorrichtung montiert ist; und
Verbindungsstifte (7) zum elektrischen Verbinden der Sonden (5) mit entsprechenden Anschlüssen (11a) der ersten Gruppe der Umsetzungskarte;
**gekennzeichnet durch**:
eine Stützkarte (8) zum Stützen der Verbindungsstifte (7) und eines Vorspannelements (15b) zum Vorspannen der Stützkarte(8) zum Abhalten der Spitzen (7b) der Verbindungsstifte (7) von der Umsetzungskarte (13), während die Vorrichtung in einer Ruhestellung ist.

2. Leiterplatten-Untersuchungsvorrichtung nach Anspruch 1, die weiterhin eine Führungsplatte (9) mit einer Vielzahl von Durchgangslöchern (9a) zum Führen der Verbindungsstifte (7) zu der ersten Gruppe von Anschlüssen (11a) der Umsetzungskarte (13) enthält, wobei die Führungsplatte (9) mit der Umsetzungskarten (13) integral gekoppelt ist.

3. Leiterplatten-Untersuchungsvorrichtung nach Anspruch 1, die weiterhin eine erste Platte (30) mit einer Vielzahl von Durchgangslöchern (30a) aufweist, von welchen jedes einen Durchmesser hat, der im wesentlichen derselbe wie derjenige des Verbindungsstifts (7) ist, um den letzteren in einer glatten Paßart aufzunehmen; eine zweite Platte (31) mit einer Vielzahl von Durchgangslöchern (31a), von welchen jedes etwas größer als dasjenige der Verbindungsstifte (7) für eine lose Passung mit den Stiften (7) ist, was einen leichten Versatz der zweiten Platte (31) relativ zu den Stiften (7) zuläßt; eine dritte Platte (32), die mit der zweiten Platte (31) und der Umsetzungskarte (13) und einem Treiberelement zum Einstellen der zweiten und der dritten Platte (31, 32) und der Umsetzungskarte (13) relativ zu den Stiften (7) integral gekoppelt ist.

4. Leiterplatten-Untersuchungsvorrichtung nach einem der Ansprüche 1 bis 3, wobei das vorbestimmte Muster eine Matrix ist und die Stützkarte (8) eine Vielzahl von Durchgangslöchern (8a) enthält, die in der Matrix angeordnet sind, wobei jeder der Verbindungsstifte (7) einen vergrößerten Kopf (7a) hat, um an einer oberen Seite der Stützkarte gehalten zu werden, und wobei ein Durchmesser jedes Durchgangslochs (8a) größer als ein Durchmesser des jeweiligen Verbindungsstifts (7) ist, der dort hindurch verläuft.

## Revendications

1. Appareil d'inspection pour inspecter la conductivité entre et parmi des points d'inspection sur une carte de circuit imprimé, ledit appareil comprenant :
une pluralité de sondes (5) disposées dans un modèle prédéterminé ;
une carte de translation (13) comprenant un premier jeu de bornes (11a) disposées dans le même modèle que celui des sondes et un second jeu de bornes (11c) disposées dans le même modèle que celui des points d'inspection sur une carte de circuit imprimé à inspecter, le premier jeu de bornes (11a) étant respectivement électriquement interconnecté avec des bornes correspondant au second jeu (11c), la carte de translation (13) étant montée de façon interchangeable sur l'appareil ; et
des broches d'interconnexion (7) pour interconnecter électriquement les sondes (1) avec des bornes correspondantes (11a) du premier jeu de la carte de translation ;
**caractérisé par** :
une carte de support (8) pour supporter les broches d'interconnexion (7) et un élément de tension (15b) pour tendre la carte de support (8) pour ne pas approcher les extrémités (7b) des broches d'interconnexion (7) de la carte de translation (13) alors que l'appareil est repos.

2. Appareil d'inspection de carte de circuit imprimé selon la revendication 1, comprenant en outre une plaque de guide (9) comprenant une pluralité de trous traversants (9a) pour guider les broches d'interconnexion (7) vers le premier jeu de bornes (11a) de la carte de translation (13), ladite plaque de guide (9) étant couplée intégralement avec la carte de translation (13).

3. Appareil d'inspection de carte de circuit imprimé selon la revendication 1, comprenant en outre une première plaque (30) ayant une pluralité de trous traversants (30a) chacun ayant un diamètre substantiellement le même que celui de la broche d'interconnexion (7) pour recevoir cette dernière de manière à s'ajuster parfaitement ; une seconde plaque (31) ayant une pluralité de trous traversants (31a) dont chacun est légèrement plus grand que celui des broches d'interconnexion (7) pour un ajustement lâche avec les broches (7), permettant un léger déplacement de la seconde plaque (31) par rapport aux broches (7) ; une troisième plaque (32) couplée intégralement à la seconde plaque (31) et la carte de translation (13) et un élément de commande pour ajuster les seconde et troisième plaques (31, 32) et à la carte de translation (13) par rapport aux broches (7).

4. Appareil d'inspection de carte de circuit imprimé selon l'une quelconque des revendications 1 à 3, dans lequel le modèle prédéterminé est une matrice et la carte de support (8) comprend une pluralité de trous traversants (8a) disposés dans ladite matrice, chacune des broches d'interconnexion (7) ayant une tête agrandie (7a) afin d'être maintenue sur un côté supérieur de la carte de support et où un diamètre de chaque trou traversant (8a) est plus grand que le diamètre de la broche d'interconnexion respective (7) passant à travers.
